Europäisches Patentamt

European Patent Office

Office européen des brevets

(11) Numéro de publication: **0 235 483**
**A1**

(12) **DEMANDE DE BREVET EUROPEEN**

(21) Numéro de dépôt: **86402962.4**

(51) Int. Cl.4: **H03M 1/34 , H03M 1/14**

(22) Date de dépôt: **30.12.86**

(30) Priorité: **10.01.86 FR 8600305**

(43) Date de publication de la demande:
**09.09.87 Bulletin 87/37**

(84) Etats contractants désignés:
**BE CH DE GB LI NL**

(71) Demandeur: **Kalfon, René**
**816, rue de la Haie**
**F-76230 Bois Guillaume(FR)**

(72) Inventeur: **Kalfon, René**
**816, rue de la Haie**
**F-76230 Bois Guillaume(FR)**

(74) Mandataire: **Martinet & Lapoux**
**62, rue des Mathurins**
**F-75008 Paris(FR)**

(54) **Circuit de quantification acylique à vitesse de fonctionnement élevée.**

(57) Le circuit de quantification est acyclique, c'est-à-dire indépendant d'une quelconque fréquence d'horloge, permet une quantification continue et instantanée d'un signal entrant et offre une vitesse de fonctionnement élevée. Il comprend des cellules ($C_0$, $C_{i-1}$) pour détecter une tension instantanée du signal entrant dans des intervalles de tension consécutifs. Une sortie ($BS_i$) de l'une ($C_i$) des cellules signale par un état logique différent de celui des sorties des autres cellules, une tension instantanée comprise dans l'intervalle associé à ladite cellule. Chaque cellule ne comprend que quelques composants électroniques discrets afin d'offrir une vitesse de conversion supérieure au MHz.

FIG.1

## Circuit de quantification acyclique à vitesse de fonctionnement élevée

La présente invention concerne d'une manière générale un circuit pour quantifier un signal de tension entrant dans des intervalles de tension consécutifs, en vue de convertir le signal entrant en un signal numérique. En particulier, le signal entrant est un signal analogique à basse fréquence tel qu'un signal téléphonique, destiné à être multiplexé temporellement dans un équipement de multiplexage de voies téléphoniques.

Actuellement, dans un équipement de multiplexage de voies téléphoniques, les fonctions d'échantillonnage, de quantification et de codage réalisant une conversion analogique-numérique sont accomplies par un codeur recevant typiquement 30 signaux téléphoniques analogiques. Après échantillonnage cyclique des signaux analogiques, le échantillons des signaux sont transmis en série à un circuit de comparaison de tension bouclé à travers une logique de codage et un générateur de tensions de référence. Pour chaque échantillon de tension V et selon un cycle fixe et incompressible ayant une durée de 3,9 $\mu$s et décomposée en huit intervalles de temps élémentaires $\theta_1$ à $\theta_8$ de 0,487 $\mu$s chacun, le codeur détermine l'octet de quantification S.ABC.WXYZ, selon le processus suivant.

a) Détermination du bit de signe S.
Pendant les quatre premiers intervalles de temps élémentaires $\theta_1$ à $\theta_4$, le signal est comparé à "0" volt ce qui conduit à définir le bit de signe S, tel que S = 1 si V > 0 et S = 0 si V < 0, et à programmer un gain d'amplification G égal à 8 si $|V|$ < $V_{max}$/8, ou égal à 1 si V > $V_{max}$/8, où $V_{max}$ est la tension crête maximale de quantification.

b) Détermination des trois bits ABC correspondant à un segment de quantification, de largeur $V_{max}$/8 lorsque la loi de quantification est uniforme, pendant les intervalles de temps élémentaires $\theta_5$ et $\theta_6$. Cette détermination se fait par des "pesées" successives qui situent l'échantillon à coder entre deux tensions consécutives, parmi huit tensions de référence préfixées.

c) Détermination des quatre derniers bits WXYZ correspondant à la position d'un échelon de quantification WXYZ parmi 16 valeurs dans le segment ABC. Les intervalles $\theta_7$ et $\theta_8$ sont utilisés pour situer l'amplitude de l'échantillon à coder par rapport au 16 échelons qui sont "cadrés" dans le segment ABC défini précédemment en appliquant au circuit de comparaison des tensions de référence mémorisées qui délimitent le segment ABC repéré précédemment.

Pendant toute la durée du cycle de 3,9 $\mu$s, l'échantillon est mémorisé par une mémoire analogique sous la forme d'un condensateur de 1 nF placé entre un amplificateur adapteur d'impédance et un amplificateur séparateur, la mémoire ayant un cycle d'écriture, lectures, effacement qui s'inscrit dans les 3,9 $\mu$s du cycle du codeur.

La logique de codage opère donc séquentiellement et, dans le matériel de nouvelle génération, est réalisée au moyen d'un microprocesseur. Dans ces conditions, la durée de conversion d'un échantillon de tension en un octet est relativement longue et ne peut être inférieure à quelques microsecondes. Cette vitesse de fonctionnement du codeur relativement lente limite ainsi le nombre de signaux téléphoniques que peut traiter le codeur. Pour ces raisons, en pratique, un tel codeur traite trente voies téléphoniques en vue de constituer un multiplex de trente-deux voies à 2048 kbit/s, deux voies convoyant un octet de verrouillage de trame et un octet de signalisation.

La présente invention vise principalement à fournir un circuit de quantification acyclique, c'est-à-dire indépendant d'une quelconque fréquence d'horloge et permettant une quantification continue et instantanée, et non séquentielle, contrairement à la technique antérieure évoquée ci-dessus. Plus précisémment, un circuit de quantification selon l'invention est du type défini dans la préambule de la revendication 1, c'est-à-dire offrant des sorties associées respectivement à des intervalles de quantification prédéterminés de la tension d'entrée à quantifier.

Un tel circuit de quantification est par exemple décrit dans le brevet US-A-3 585 631. Ce circuit de quantification jouant le rôle d'un convertisseur anologique-nummérique comprend des cellules de détection incluant chacune des convertisseurs classiques à seuils de tension, tels qu'amplificateurs opérationnels ou étages différentiels à transistors. Cependant de tels circuits sont d'une part coûteux, et offrent une consommation en courant relativement élevée et surtout une vitesse de fonctionnement relativement faible ne permettant pas une quantification rapide supérieure au mégahertz.

Ainsi, la présente invention vise plus particulièrement un circuit de quantification offrant une vitesse de fonctionnement élevée, c'est-à-dire uniquement limitée par des temps de propagation à travers quelques composants électroniques discrets en vue d'utiliser le circuit de quantification pour un nombre élevé de voies à basse fréquence.

Selon l'invention, un circuit quantifiant un signal de tension entrant dans des premiers intervalles de tension consécutifs, est tel que caractérisé dans la revendication 1.

Dans ces conditions, les sorties du circuit de quantification signalent d'une manière continue les niveaux de quantification de la tension instantanée du signal analogique de tension. Un mot constitué par les états des bornes de sortie des cellules et donc n'ayant qu'un bit à l'état prédéterminé peut être prélevé périodiquement, à une fréquence d'échantillonnage, afin de le transcoder au moyen d'une mémoire morte, par exemple en un octet afin d'obtenir en sortie un signal numérique MIC conventionnel. La fréquence d'échantillonnage n'est donc pas tributaire d'une quelconque fréquence de cycle d'une logique de codage, et peut être supérieure au MHz. Ceci permet d'utiliser un seul circuit de quantification selon l'invention pour quantifier un très grand nombre de voies téléphoniques, de l'ordre de plusieurs centaines, et donc d'obtenir directement un multiplex de voies d'ordre hiérarchique très élevé sans multiplexeurs intermédiaires.

Selon d'autres caractéristiques de l'invention, dans chaque cellule, les moyens de division de tension et des moyens de signalisation, intermédiaires entre les moyens de division et la forme de sortie de la cellule, ne sont constitués que par des composants électroniques classiques ce qui réduit considérablement le coût d'un dispositif de conversion analogique-numérique incluant un circuit de quantification selon l'invention. En particulier, les moyens de signalisation sont tels que définis dans les revendications 3 et 4.

Selon d'autres caractéristiques de l'invention destinées à affiner la quantification selon une loi de quantification connue ayant typiquement $I.J = 16.16 = 256$ niveaux, le circuit de quantification comprend un premier quantificateur incluant lesdites premières cellules pour quantifier le signal entrant dans les premiers intervalles, et un second quantificateur incluant des secondes cellules analogues aux premières cellules et des moyens de sélection de tension pour appliquer auxdites secondes cellules les tensions limites du premier intervalle associé à une première cellule détectant ayant une borne de sortie audit état logique prédéterminé afin que lesdites secondes cellules détectent respectivement une tension instantanée du signal entrant dans des seconds intervalles de tension consécutifs partageant le premier intervalle associé à la première cellule détectant.

D'autres avantages et caractéristiques de l'invention apparaîtront plus clairement à la lecture de la description suivante de plusieurs réalisations de l'invention en référence aux dessins annexés correspondants dans lesquels :

-la Fig.1 est un bloc diagramme du circuit de quantification selon l'invention ;

-la Fig.2 montre en détail un premier quantificateur inclus dans le circuit de quantification, pour quantifier un signal de tension dans des premiers intervalles de quantification ;

-la Fig.3 montre en détail un second quantificateur inclus dans le circuit de quantification pour quantifier chacun des premiers intervalles de quantification par des seconds intervalles de quantification ;

-la Fig.4 est un bloc-diagramme - schématique d'un premier dispositif incluant le circuit de quantification pour convertir un signal analogique en un signal numérique à 2 paires d'octets ;

-la Fig.5 est un bloc-diagramme - schématique d'un second dispositif incluant le circuit de quantification pour convertir un signal analogique en un signal numérique en code MIC ; et

-la Fig.6 est un bloc-diagramme - schématique d'un troisième dispositif incluant le circuit de quantification pour convertir plusieurs signaux analogiques reçus en parallèle en des signaux numériques.

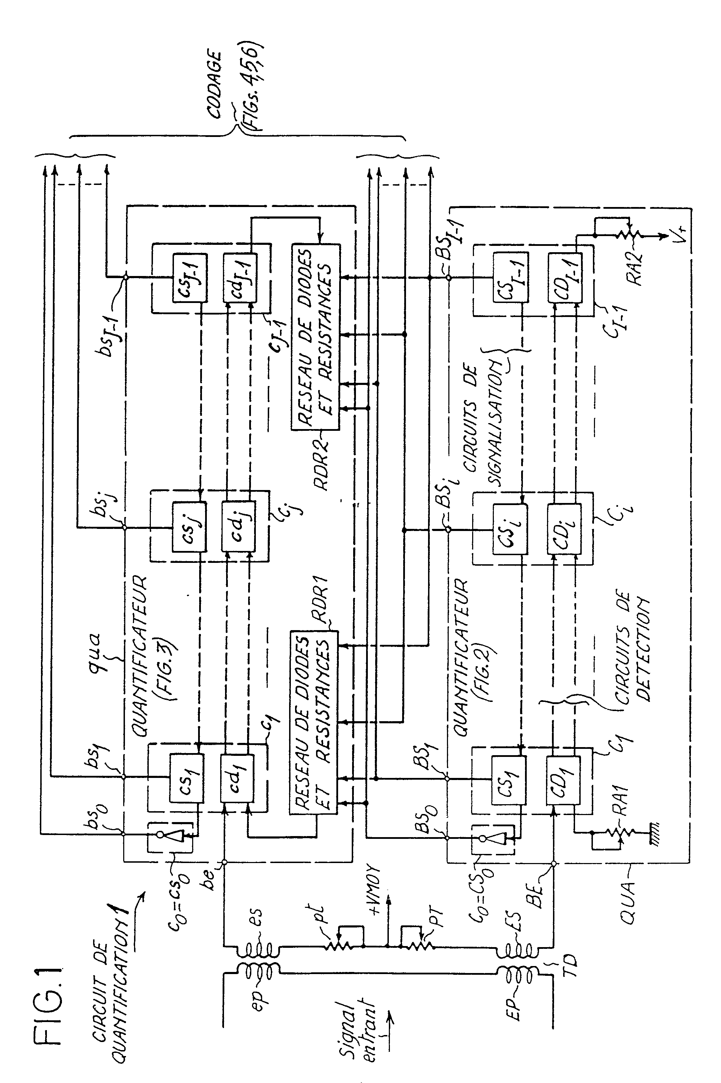

En référence à la Fig.1, un circuit de quantification 1 selon l'invention quantifie instantanément un signal entrant de tension dans $I.J = 16.16 = 256$ intervalles de quantification successifs. Le signal entrant est d'une manière générale un signal analogique qui peut être un signal de modulation en amplitude, en fréquence ou en phase ou, le cas échéant, un signal numérique.

Le circuit de quantification 1 est partagé en deux quantificateurs QUA et qua par un transformateur différentiel d'entrée TD. Le signal entrant de tension à quantifier est appliqué à deux bornes d'un double enroulement primaire EP + ep du transformateur TD et est reproduit et polarisé positivement aux bornes de deux demi-enroulements secondaires ES et es du transformateur. Chacun des demi-enroulements secondaires ES, es a une borne reliée à un potentiomètre PT, pt portée à une tension positive convenable VMOY. Les autres bornes des demi-enroulements secondaires ES et es constituent des bornes d'entrée BE, be des quantificateurs QUA et qua respectivement.

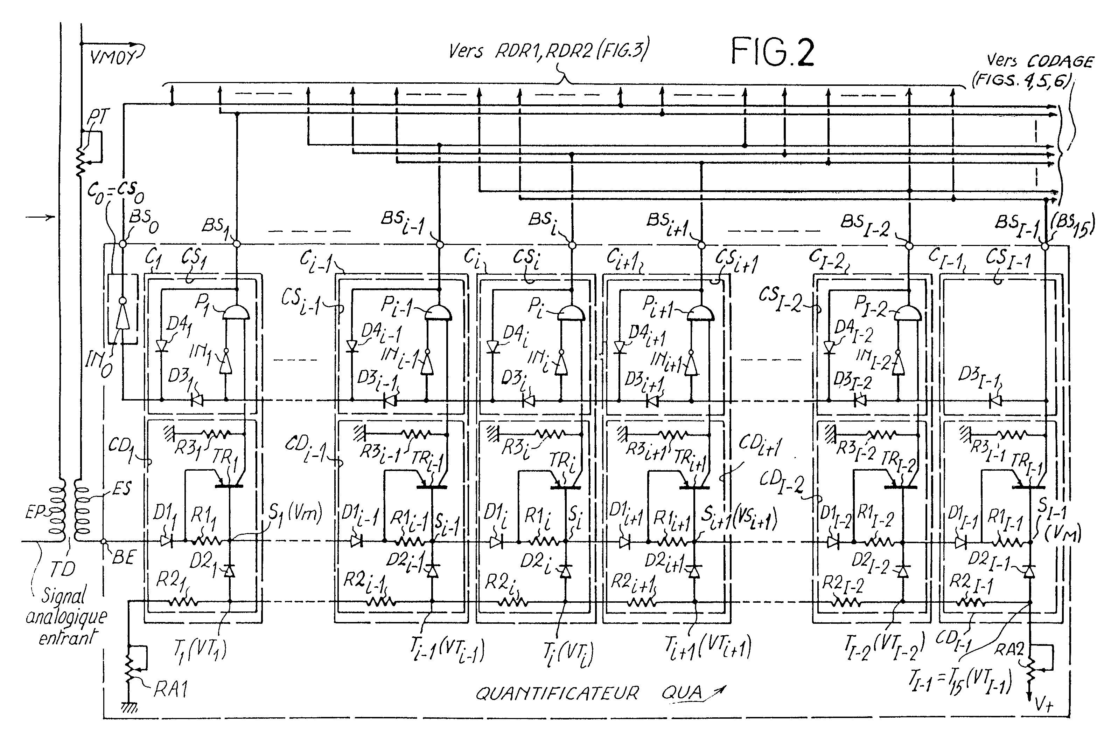

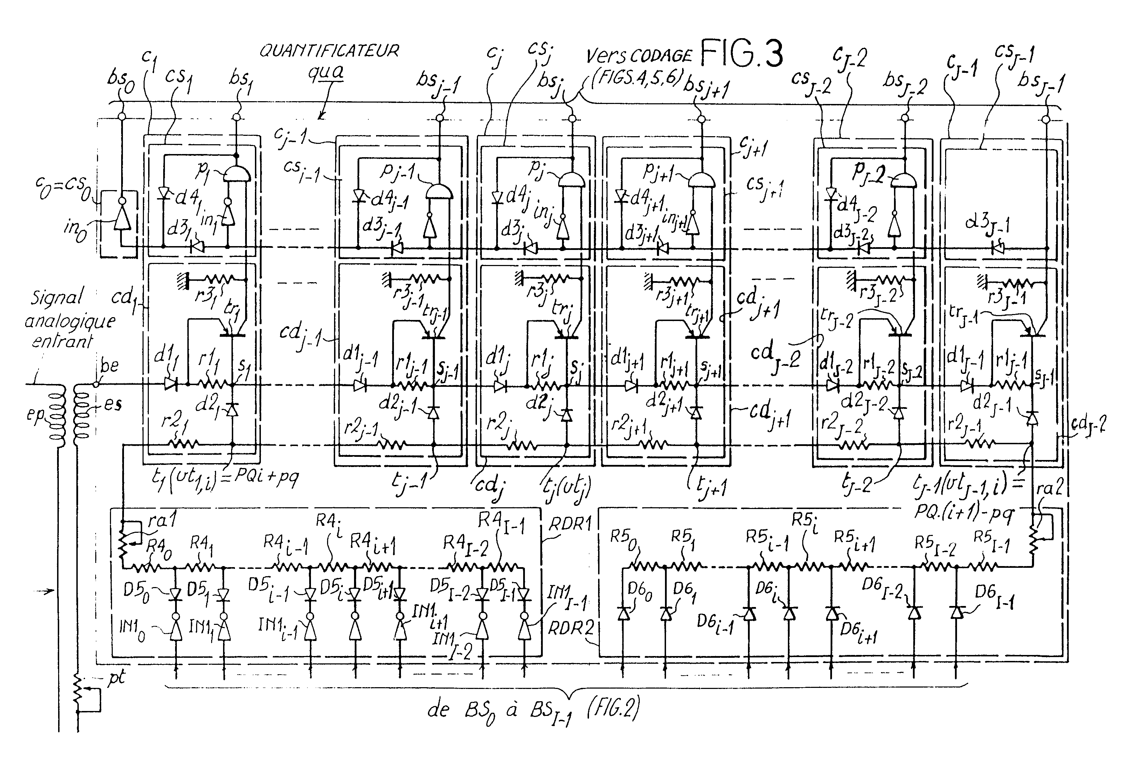

Le premier quantificateur QUA montré en détail à la Fig.2 est destiné à quantifier le signal entrant dans $I-2 = 14$ intervalles de quantification de tension $VS_2-VS_1$ à $VS_{I-1}-VS_{I-2}$ d'une plage de quantification associés à $I-2$ cellules de quantification $C_1$ à $C_{I-2} = C_{14}$. Le quantificateur QUA comprend également une première cellule $C_0$ et une dernière cellule $C_{I-1} = C_{15}$ pour indiquer une tension instantanée du signal entrant inférieure à $VS_1$ et supérieure à $VS_{I-1}$ respectivement. Toutes les cellules sont identiques à l'exception de a première $C_0$ et de la

dernière $C_{I-1}$. Chacune des cellules $C_i$ de rangs i compris entre 1 et I-2 contient un circuit de détection $CD_i$ pour détecter une tension entrante supérieure à une tension limite inférieure $VS_i$ dans un intervalle de quantification respectif $VS_i$ à $VS_{i+1}$ et un circuit de signalisation $CS_i$ pour signaler par un état logique "1" à une borne de sortie $BS_i$ une tension entrante comprise dans cet intervalle de quantification. La première cellule $C_o$ ne comprend qu'un circuit de signalisation $CS_o$ constitué par un simple inverseur $IN_o$. La dernière cellule $C_{I-1}$ contient un circuit de détection $CD_{I-1}$ analogue à ceux $CD_1$ à $CD_{I-2}$ dans les cellules $C_1$ à $C_{I-2}$, et un circuit de signalisation $CS_{I-1}$ ne comprenant qu'une diode $D3_{I-1}$.

Le circuit de détection $CD_i$ dans la cellule $C_i$ comprend une première diode d'entrée $D1_i$, un transistor bipolaire PNP $TR_i$ ayant un collecteur relié à la terre à travers une résistance $R3_i$, une résistance de polarisation de transistor $R1_i$ interconnectée entre d'une part, une cathode de la diode $D1_i$ reliée à un émetteur du transistor $TR_i$ et d'autre part, une base du transistor $TR_i$ formant une sortie de tension $S_i$ de la cellule $C_i$ et une entrée de la cellule suivante $C_{i+1}$ reliée à une anode de la diode $D1_{i+1}$ -sauf pour la dernière cellule $C_{I-1}$ -, une seconde diode $D2_i$ ayant une cathode reliée à la sortie $S_i$, et une seconde résistance $R2_i$ ayant une première borne reliée à l'anode de la diode $D2_i$ et une seconde borne reliée à l'anode de la diode $D2_{i-1}$ dans la cellule précédente $C_{i-1}$ -sauf pour la cellule $C_1$ -. La borne d'entrée BE du quantificateur QUA est reliée à une anode de la diode $D1_1$ dans la seconde cellule $C_1$, la tension entrante à quantifier, polarisée par la tension VMOY, étant appliquée à cette borne BE.

En l'absence de signal entrant, la tension à la borne BE est réglée à la tension de polarisation VMOY, qui est égale à la tension moyenne du signal entrant notamment lorsque la loi de quantification est linéaire, et qui, d'une manière générale, est comprise entre l'amplitude maximale $V_M$ correspondant à une crête positive du signal entrant, et une amplitude minimale $V_m$ correspondant à une crête négative du signal entrant. Les deux valeurs $V_m$ et $V_M$ constituent des limites en tension positive de l'amplitude crête à crête du signal entrant et définissent la plage de référence de quantification du quantificateur QUA. La valeur de la tension $VS_1 = V_m$ est appliquée à la borne $S_1$ à travers la diode $D2_1$ par une borne de référence $T_1$ dans la première cellule $C_1$ commune aux résistances $R2_1$ et $R2_2$ et à l'anode de la diode $D2_1$, et est réglée par une première résistance ajustable RA1, telle que potentiomètre, en série avec la résistance $R2_1$ et reliée à la terre. La valeur de la tension $V_M$ est appliquée à la borne $S_{I-1}$ à travers la diode $D2_{I-1}$ par une borne de référence $T_{I-1}$ dans la dernière cellule $C_{I-1} = C_{Is}$ commune à la résistance $R2_{I-1}$ et l'anode de la diode $D2_{I-1}$, et est réglée par une seconde résistance ajustable RA2, telle que potentiomètre, interconnectée entre une borne $T_{I-1}$ et la borne d'alimentation $V_+$.

Ainsi les résistances $R2_1$ à $R2_{I-1}$ en série avec les résistances ajustables RA1 et RA2 réalisent une division de la différence de tensions $VT_{I-1}-VT_1$ en I-2 premiers intervalles de quantification adjacents $VT_2-VT_1$, $VT_3-VT_2$,... $VT_i-VT_{i-1}$, $VT_{i+1}-VT_i$,... $VT_{I-1}-VT_{I-2}$, où les tensions $VT_1$ à $VT_{I-1}$ sont des tensions de référence ou dites de décision, appelées niveaux de quantification, respectivement appliquées aux bornes $T_1$ à $T_{I-1} = T_{Is}$ des résistances $R2_1$ à $R2_{I-1}$ reliées aux anodes des diodes respectives $D2_1$ à $D2_{I-1}$. Les résistances $R1_1$ à $R1_{I-1}$ sont respectivement égales aux résistances $R2_1$ à $R2_{I-1}$ ce qui permet de reporter les divisions de tension précédentes aux bornes $S_1$ à $S_{J-1}$, aux tensions de conduction négligeables des diodes $D2_1$ à $D2_{I-1}$ près. On considérera dans la suite que les niveaux de décision sont tels que $VT_1 = VS_1$ à $VT_{I-1} = VS_{I-1}$. Les résistances $R1_1$ à $R1_{I-1}$, $R2_1$ à $R2_{I-1}$ ont des valeurs ohmiques qui peuvent être égales afin de réaliser une quantification uniforme avec un pas de quantification constant égal à la largeur de chaque intervalle $VT_2-VT_1$ à $VT_{I-1}-VT_{I-2}$, ou bien peuvent être différentes selon une loi de quantification non uniforme déduite d'une fonction logarithmique par exemple, ou correspondant à une courbe de compression de niveaux de quantification habituellement utilisée en modulation par impulsions codées du type MIC.

La tension entrante appliquée à la borne BE est égale à la somme algébrique de la tension instantanée du signal entrant et de la tension de polarisation VMOY qui fixe la valeur médiane moyenne de la plage de quantification, correspondant à la tension $VS_{I/2} = VS_s$ dans la cellule $C_{I/2} = C_s$, ou à la tension $VS_{(I+1)/2}-VS_{(I-1)/2}$ lorsque I est impair, pour une quantification uniforme. La tension entrante à un instant donné est située ainsi entre deux niveaux de quantification successifs, par exemple $VS_i$ et $VS_{i+1}$ déterminés aux bornes de sortie $S_i$ et $S_{i+1}$ des cellules $C_i$ et $C_{i+1}$ et, comme déjà dit, considérés pratiquement égales aux tensions de référence $VT_i$ et $VT_{i+1}$. Dans ce cas, la diode $D1_i$ dans la cellule $C_i$ est passante puisque la tension entrante est supérieure à $VT_i$, et les diodes $D1_{i+1}$ et $D2_{i+1}$ dans la cellule suivante sont bloquées puisque la tension entrante est inférieure à $VT_{i+1}$. Ainsi toutes les autres diodes $D1_{i+1}$ à $D1_{I-1}$ et les transistors $TR_{i+1}$ à $TR_{I-1}$ dans les cellules de rang supérieur à i sont bloqués, la tension entrante étant inférieure aux tensions de référence

$VT_{i+1}$ à $VT_{i-1}$. Par contre, les diodes $D1_1$ à $D1_i$ de rang inférieur ou égal à i sont débloquées et les transistors $TR_1$ à $TR_i$ dans les cellules $C_1$ à $C_i$ sont conducteurs.

Dans chacune des cellules $C_1$ à $C_{i-2}$, le circuit de signalisation $CS_1$ à $CS_{i-2}$ comprend une porte ET $P_1$ à $P_{i-2}$ ayant une première entrée reliée à une sortie de commande du circuit de détection $CD_1$ à $CD_{i-2}$ constituée par le collecteur du transistor $TR_1$ à $TR_{i-2}$, une seconde entrée reliée à une anode d'une troisième diode $D3_1$ à $D3_{i-2}$ dans la cellule $C_1$ à $C_{i-2}$ et à une cathode de la diode $D3_2$ à $D3_{i-1}$ dans la cellule suivante $C_2$ à $C_{i-1}$ à travers un inverseur $IN_1$ à $IN_{i-2}$, et une sortie constituant la borne de sortie de signalisation $BS_1$ à $BS_{i-2}$ de la cellule $C_1$ à $C_{i-2}$, reliée à une anode d'une quatrième diode $D4_1$ à $D4_{i-2}$ ayant une cathode reliée à celle de la diode $D3_1$ à $D3_{i-2}$. Le circuit de signalisation $CS_{i-1}$ dans la dernière cellule $C_{i-1}$ ne comprend que la diode $D3_{i-1}$ ayant une anode reliée à la borne $BS_{i-1}$ et au collecteur du transistor $TR_{i-1}$.

Lorsque la tension entrante est comprise entre $VT_i$ et $VT_{i+1}$ et sature le transistor $TR_i$ de la cellule $C_i$, la porte ET $P_i$ est ouverte, puisque la seconde entrée de la porte $P_i$ est à l'état logique "1" du fait que les diodes $D3_{i+1}$ à $D3_{i-1}$ dans les cellules suivantes sont bloquées par les transistors $TR_{i+1}$ à $TR_{i-1}$ non conducteurs. La borne de sortie $BS_i$ est à l'état "1" et rend passante la quatrième diode $D4_i$ qui impose un état "1" aux entrées des inverseurs $IN_0$ à $IN_{i-1}$ et donc un état "0" aux secondes entrées de toutes les portes $P_1$ à $P_{i-1}$ dans les cellules de rang inférieur. Ainsi, bien que les transistors $TR_1$ à $TR_{i-1}$ soient conducteurs, les portes $P_1$ à $P_{i-1}$ sont fermées. Il en résulte que toutes les bornes de sortie $BS_1$ à $BS_{i-1}$ et $BS_{i+1}$ à $BS_{i-1}$ du quantificateur QUA sont à l'état "0" et, seule, la borne $BS_i$ est à l'état "1" pour signaler une tension instantanée entrante comprise dans l'intervalle de quantification $VT_i$ à $VT_{i+1}$.

Lorsque la tension entrante est supérieure à $VT_{i-1}$, la borne $BS_{i-1}$ est à l'état "1" pour signaler un dépassement de la valeur maximale $V_M = VT_{i-1}$, c'est-à-dire une tension instantanée comprise entre $V_M$ et $V_+$. Lorsque la tension entrante est inférieure à $V_m = VT_1$, la borne $BS_0$ reliée aux cathodes des diodes $D3_1$ et $D4_1$ à travers l'inverseur $IN_0$ est à l'état "1" et signale un dépassement vers le bas de la valeur crête négative $V_m = VT_1$, c'est-à-dire une tension instantanée comprise entre 0 Volt et $V_m$.

On notera que le quantificateur QUA, ou plus généralement, le circuit de quantification 1 produit une quantification du signal entrant quasi-instantanée au déphasage près, et de manière continue, et est totalement indépendant d'une fréquence d'horloge. Une horloge intervient, comme on le verra dans la suite, uniquement au cours d'une opération d'échantillonnage consistant à lire les états des bornes de sortie du circuit de quantification et à détecter un état "1" sur l'une des sorties $BS_0$ à $BS_{i-1}$ et sur l'une des sorties de l'autre quantificateur qua pendant une période d'échantillonnage $T_e$.

Le second quantificateur qua est destiné à affiner la quantification du signal entrant dans chacun des premiers intervalles de tension $<VT_1$, $VT_2$-$VT_1$ à $VT_{i-1}$-$VT_{i-2}$ et $>VT_{i-1}$. Comme montré à la Fig.3, le quantificateur qua selon la réalisation illustrée contient un réseau de J secondes cellules $c_0$, $c_1$ à $c_{J-2}$ et $c_{J-1}$ respectivement identiques aux premières cellules $C_0$, $C_1$ à $C_{i-2}$, $C_{i-1}$. Le nombre J de cellules de quantification dans le quantificateur qua peut être égal à celui I dans le quantificateur QUA, comme dans la réalisation préférée pour laquelle I = J = 16, ou peut être différent de celui-ci. Dans chaque cellule $c_j$ montrée à la Fig.3, des composants, tels que diodes $d1_j$ et $d2_j$, résistances $r1_j$, $r2_j$ et $r3_j$ et transistor $tr_j$, dans un circuit de détection de tension $cd_j$, et des composants, tels que diodes $d3_j$ et $d4_j$, porte ET à deux entrées $P_j$ et inverseur $in_j$ dans un circuit de signalisation $cs_j$, et des bornes be, $t_j$, $s_j$ et $bs_j$, sont respectivement désignés par des lettres minuscules correspondant aux lettres majuscules désignant des composants et bornes analogues pour une cellule $C_i$ dans la Fig.2. Ainsi, la borne be du second demi-enroulement secondaire es du transformateur différentiel TD constitue une borne d'entrée du quantificateur qua reliée à l'anode $d1_1$ dans la première cellule $c_1$, et le quantificateur qua offre J = 16 bornes de sorties $bs_0$ à $bs_{J-1}$ respectivement reliées à la sortie de l'inverseur $in_0$ dans la cellule $c_0$, aux sorties des portes ET $p_1$ à $p_{J-2}$ dans les cellules $c_1$ à $c_{J-2}$, et à l'anode de la diode $d3_{J-1}$ et au collecteur du transistor $tr_{J-1}$ inclus dans la dernière cellule $c_{J-1}$.

Des tensions de référence $vt_1$ et $vt_{J-1}$ aux bornes $t_1$ et $t_{J-1}$ des cellules $c_1$ et $c_{J-1}$ sont fixées en fonction des limites de l'un des premiers intervalles de quantification correspondant à la tension instantanée du signal entrant et marqué par l'état "1" à l'une des bornes de sortie $BS_0$ à $BS_{J-1}$ au moyen de deux réseaux de diodes et résistances. L'un, RDR1, de ces réseaux, correspondant à la résistance RA1 dans le quantificateur QUA, fixant des tensions limites inférieures assignées aux cellules $c_1$ à $c_{J-1}$, est composé d'une résistance ajustable ra1, telle que potentiomètre, ayant une première borne reliée à la résistance $r2_1$ dans la première cellule $c_1$, de résistances $R4_0$ à $R4_{i-1}$ reliées en série à partir d'une seconde borne de la résistance ra1, de diodes $D5_0$ à $D5_{i-1}$, et d'inverseurs $IN1_0$ à $IN1_{i-1}$ interconnectés respectivement entre les bornes de sortie $BS_0$ à $BS_{i-1}$ du quantificateur QUA et des cathodes des diodes $D5_0$ à $D5_{i-1}$. L'une des bornes de la résistance $R4_0$ est reliée

à la seconde borne de la résistance ra1. Des anodes des diodes $D5_0$ à $D5_{I-1}$ sont respectivement reliées à des bornes communes aux résistances $R4_0$ et $R4_1$ à $R4_{I-2}$ et $R4_{I-1}$, et à une autre borne de la résistance $R4_{I-1}$. Le second réseau de diodes et résistances RDR2, correspondant à la résistance RA2 dans le quantificateur QUA, fixant des tensions limites supérieures assignées aux cellules $c_1$ à $c_{J-1}$ comprend une résistance ajustable ra2, telle que potentiomètre, ayant une première borne reliée à la borne $t_{J-1}$ de la cellule $c_{J-1}$, des résistances $R5_{I-1}$ à $R5_0$ reliées en série à partir d'une seconde borne de la résistance ra2, et des diodes $D6_{I-1}$ à $D6_0$ ayant des anodes reliées respectivement aux bornes $BS_{I-1}$ à $BS_0$ du quantificateur QUA et des cathodes reliées respectivement à des bornes communes aux résistances $R5_{I-1}$ et $R5_{I-2}$ à $R5_1$ et $R5_0$ et à une autre borne de la résistance $R5_0$. La seconde borne de la résistance ajustable ra2 est reliée à la résistance $R5_{I-1}$.

Les résistances $R4_0$ à $R4_{I-1}$ et $R5_0$ à $R5_{I-1}$ ont des valeurs ohmiques permettant de reporter les tensions limites $VT_0$, $VT_1$ à $VT_{I-1}$ et $VT_I$ des intervalles de quantification du quantificateur QUA dans le second quantificateur qua, $VT_0$ et $VT_I$ désignant des tensions de référence de premier et dernier intervalles de quantification $VT_0$ à $VT_1$ et $VT_{I-1}$ à $VT_I$ de la plage de quantification, en pratique respectivement égales à 0 Volt et $V_+$.

On suppose dans la suite, que la quantification est uniforme dans les quantificateurs QUA et qua, et que $PQ = VT_I/I$ désigne un premier pas de quantification égal à la largeur des premiers intervalles de quantification et pq désigne un second pas de quantification dans le second quantificateur qua partageant chaque premier intervalle $VT_1$-$VT_0$ à $VT_I$-$VT_{I-1}$ en J = 16 seconds intervalles de quantification de largeur pq. On suppose également que la plage de quantification est comprise entre $VT_0 = 0$ volt et $VT_I = 5$ volts, et que $VT_I$ = 5 volts désigne également la tension à l'une des bornes de sortie $BS_0$ à $BS_{I-1}$ à l'état "1". Les pas PQ et pq sont donc égaux à $VT_I/I$ = 5/16≈0,312 V et à $VT_I$ /I/J = 312/16≈19 mV.

Par exemple, lorsque la tension instantanée du signal entrant aux bornes BE et be est comprise entre $VT_i$ et $VT_{i+1}$, la borne de sortie $BS_i$ de la cellule $C_i$ est à l'état "1". Dans le second réseau de diodes et résistances RDR2, seule la diode $D6_i$ est passante et permet d'appliquer à travers les résistances $R5_i$ à $R5_{I-1}$ et ra2, une tension à la borne $t_{J-1}$ égale à $vt_{J-1,i}$ = $VT_{i+1}$-pq = $(VT_I/I)(i+1)$ -pq. A l'autre extrémité du quantificateur qua, dans le premier réseau de diodes et résistances RDR1, l'inverseur $IN1_i$ met à la terre la cathode de la diode $D5_i$, et, à travers les résistances ra1 et $R4_0$ à $R4_i$, fixe une tension à la borne $t_1$ égale à $vt_{1,i}$ = $VT_i$+pq = $(VT_I/I)i$ + pq. Dans les deux réseaux,

les autres diodes $D6_0$ à $D6_{i-1}$, $D6_{i+1}$ à $D6_{I-1}$, $D5_0$ à $D5_{i-1}$ et $D5_{i+1}$ à $D5_{I-1}$ sont bloquées et isolent les bornes de sortie $BS_0$ à $BS_{i-1}$ et $BS_{i+1}$ à $BS_{I-1}$ par rapport au réseau de cellules $c_0$ à $c_{J-1}$ dans le quantificateur qua. Les cellules $c_0$ à $c_{J-1}$ quantifient ainsi le signal entrant dans des intervalles ($vt_{0,i}$, $vt_{1,i}$) à ($vt_{J-1,i}$, $vt_{J,i}$) ayant une largeur pq, les tensions $vt_{0,i}$ et $vt_{J,i}$ étant égales à $VT_i$ et $VT_{i+1}$ respectivement, et les tensions $vt_{1,i}$, $vt_{2,i}$,... $vt_{j,i}$,... $vt_{J-1,i}$ étant respectivement portées aux bornes $t_1$ à $t_{J-1}$. Dans ce cas, l'une des sorties $bs_j$, avec j compris entre 0 et J, est à l'état "1" pour indiquer une tension instantanée du signal entrant comprise dans le second intervalle correspondant ($vt_{j,i}$, $vt_{j+1,i}$).

Bien entendu, des valeurs limites de premiers et seconds intervalles peuvent être choisies différentes de celles selon l'exemple ci-dessus. Les tensions $VT_1$ et $VT_{I-1}$ sont ajustées en réglant les résistances RA1, RA2, ra1 et ra2, le pas PQ ou, les tensions limites des premiers intervalles de quantification en sélectionnant les valeurs ohmiques des résistances $R1_1$ à $R1_{I-1}$, $R2_1$ à $R2_{I-1}$, $R4_0$ à $R4_{I-1}$ et $R5_0$ à $R5_{I-1}$, et le pas pq ou les tensions limites des seconds intervalles de quantification en sélectionnant les valeurs ohmiques des résistances $r1_1$ à $r1_{J-1}$ et $r2_1$ à $r2_{J-1}$. En outre, la valeur médiane de la plage de quantification est ajustée en réglant les résistances PT et pt.

Ainsi à un instant donné, une quantification de la tension instantanée du signal entrant est marquée par deux bornes de sortie $BS_i$ et $bs_j$ à l'état "1", parmi I.J = 256 niveaux de quantification possible. Comme déjà dit, les nombres I et J de cellules dans les quantificateurs QUA et qua peuvent être différents. De même, par le choix des résistances $R1_1$ à $R1_{I-1}$, $R2_1$ à $R2_{I-1}$, $R4_0$ à $R4_{I-1}$ et $R5_0$ à $R5_{I-1}$, et des résistances $r1_1$ à $r1_{J-1}$ et $r2_1$ à $r2_{J-1}$, les lois de quantification dans les quantificateurs peuvent être différentes.

En outre, bien que les figures illustrent une réalisation comprenant deux étages quantificateurs QUA et qua, l'invention concerne également des circuits de quantification comprenant X + 1 étages quantificateurs QUA, $qua_1$, $qua_2$, ...$qua_X$ en cascade, les étages $qua_1$ à $qua_X$ étant analogues au quantificateur qua, et les entrées des réseaux à diodes et résistances, tels que les réseaux RDR1 et RDR2, dans chaque étage $qua_{x+1}$, où $1 \leq x < X$, étant reliés aux sorties, telles que les sorties $bs_j$, de l'étage précédent $qua_x$.

De cette manière, on peut soit augmenter indéfiniment le nombre des niveaux quantifiés en portant ce nombre à $A^{X+1}$ où A désigne un nombre d'intervalles de quantification par chaque étage et X + 1 un nombre d'étages assemblés ; soit dans le cas particulier d'un circuit de quantification offrant 2 intervalles de quantification par étage et comportant X + 1 = 8 étages quantificateurs en cascade, on obtient ainsi directement à partir de bornes de sortie BS bs₁... bs_X des étages, un mot d'un octet, ou plus, caractérisant le signal quantifié.

Lorsqu'un signal sinusoïdal entrant est appliqué au transformateur d'entrée TD du circuit de quantification 1, le temps pendant lequel une cellule $C_i$ est activée dépend de la vitesse de variation de la tension V du signal, soit dV/dt. Compte tenu du rapport des tensions limites relatives aux cellules $C_i$ et $c_j$, le temps d'activation de la cellule $C_i$ est systématiquement J = 16 fois plus grand que celui de la cellule $c_j$. Ainsi, pour un signal entrant donné et une quantification linéaire, c'est-à-dire proportionnelle à la tension, les valeurs de tension extrêmes du signal ou crêtes sont marquées pendant un temps plus long que les valeurs de tension intermédiaires de la sinusoïde, puisque dV/dt est voisin de zéro au voisinage des crêtes et il est maximum au voisinage de la tension moyenne du signal. A mesure que la fréquence du signal augmente, les temps d'activation des cellules intermédiaires, telles que $C_{I/2}$ et $c_{J/2}$ se réduisent. Lorsque les temps d'activation diminuent et atteignent une valeur limite égale au temps de propagation d'une cellule, celle-ci ne réagit plus. On constate donc progressivement une absence de quantification par les cellules intermédiaires du second quantificateur qua d'abord, puis dans les cellules intermédiaires du premier quantificateur QUA ensuite. Une limite de fonctionnement du circuit de quantification est atteinte lorsque les deux valeurs extrêmes du signal sont seulement quantifiées par une seule cellule dans le premier quantificateur QUA qui marque les valeurs extrêmes du signal. Tout se passe alors comme si le signal sinusoïdal n'était quantifié qu'à raison de deux mesures par période, cette période minimale du signal entrant définissant ainsi une limite inférieure d'une période d'échantillonnage du signal en vue de son codage, comme on le verre dans la suite. On sait que dans ces conditions la quantification demeure significative, ce qui est le cas pour un signal téléphonique MIC ayant une largeur de bande de 4 kHz, échantillonné à 8 kHz.

Si la quantification utilise une loi non linéaire et notamment une loi de compression qui réduit la largeur des intervalles de quantification à mesure que la valeur absolue de la tension du signal augmente, le même raisonnement s'applique à ce cas, mais du fait de la réduction de la largeur des intervalles de quantification au voisinage des crêtes, la limite de quantification est atteinte pour des fréquences plus basses pour le niveau de crête du signal. Ainsi l'utilisateur choisit une fonction de quantification en sachant s'il doit donner la priorité au traitement des fréquences élevées ou à la réduction de l'erreur de quantification.

Dans ce qui suit, il est admis, pour simplifier, que la loi de quantification est une fonction linéaire, ce qui conduit à une évaluation meilleure des performances du circuit de quantification 1 que celle obtenue lorsqu'il y a compression.

Selon les hypothèses précédentes, le signal analogique de fréquence F appliqué à l'entrée du circuit de quantification 1 est sous la forme V = A sin 2πFt, où A est l'amplitude du signal au plus égale à $(VT_1-VT_0)/2$, et $VT_1$ et $VT_0$ sont les tensions maximum et minimum positives admises sans écrêtage par le circuit de quantification. Avec une loi linéaire de quantification, l'intervalle $VT_1-VT_0$ est découpé en 16 intervalles égaux correspondants au 16 niveaux du quantificateur QUA.

Chaque quart de période de la sinusoïde du signal correspondant à un quadrant de phase de 0 à π/2 traverse huit intervalles de quantification en montant de la tension moyenne $(VT_1+VT_0)/2$ vers la tension maximum $VT_1$ pour le premier quadrant, puis pour le second quadrant ces mêmes intervalles en sens inverse de la tension maximum à la tension moyenne, puis pour le troisième quadrant huit intervalles de la tension moyenne à la tension minimum, et enfin pour le quatrième quadrant les huit intervalles précédents dans le sens inverse de la tension minimum à la tension moyenne.

La cellule qui signale la valeur de crête du signal est donc marquée pendant une durée égale au double de celle correspondant à un marquage de son intervalle de quantification ce qui, ajouté au fait que la variation de la tension V offre dans cette zone les valeurs les plus faibles de sa dérivée dV/dt≈0, accentue l'allongement du temps d'activation de la cellule. Cette observation concernant la variation du signal au voisinage des crêtes concerne n'importe quel intervalle de quantification selon la valeur de l'amplitude du signal et non pas seulement les cellules extrêmes $C_0$ et $C_I$ du quantificateur QUA. Il apparaît cependant qu'à fréquence égale, dV/dt = A.2πF cos 2πF au niveau d'une crête diminue en même temps que l'amplitude du signal et dt augmente si dV est constant.

Ainsi la fréquence limite de fonctionnement du quantificateur dépend de la loi de quantification et de l'amplitude du signal.

Dans ce qui suit, on suppose que l'amplitude du signal a la valeur maximum admise sans écrêtage par le circuit de quantification, hypothèse qui comme on l'a vu, conduit aux plus mauvais résultats, et que la loi de quantification est linéaire ce qui conduit inversement au meilleur résultat.

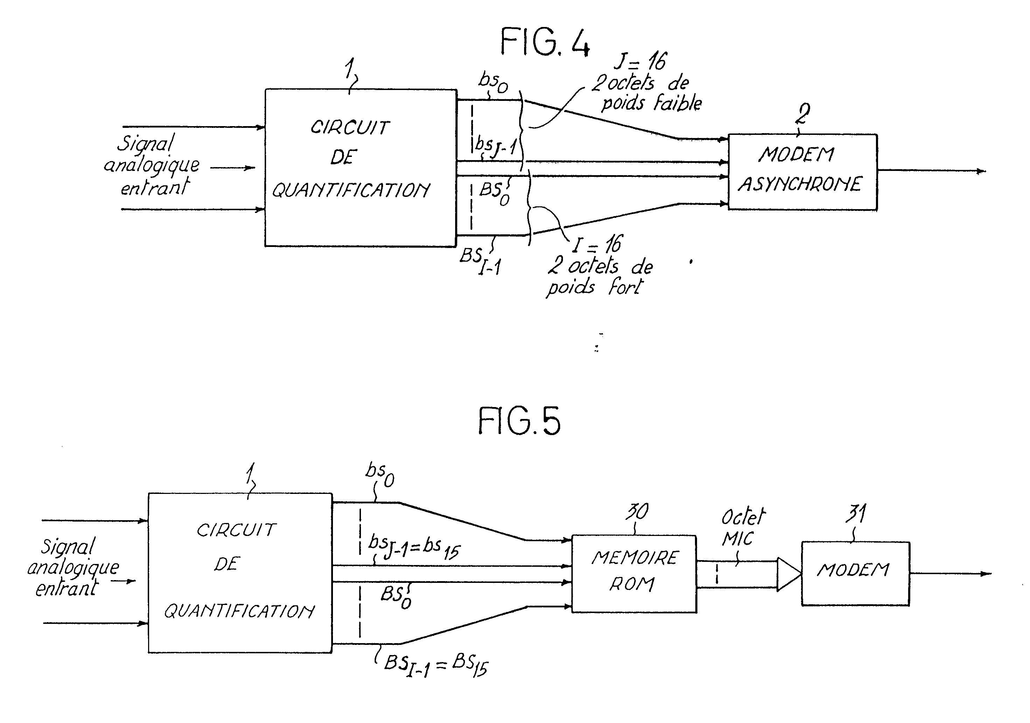

Selon une première application du circuit de quantification consistant à réaliser un "numériseur en mode direct", les I sorties $BS_0$ à $BS_I$ et les J sorties $bs_0$ à $bs_j$ forment un bus d'entrée d'un modulateur d'un modem asynchrone 2 opérant à une vitesse très élevée, comme montré à la Fig.4.

Le signal entrant dans le circuit de quantification 1 est un signal analogique correspondant par exemple à un groupe de voies téléphoniques multiplexés en fréquence. Les états des $I = 16$ sorties du quantificateur QUA et des $J = 16$ sorties du quantificateur qua sont échantillonnés et transmis sous forme de 32 bits en parallèle par le modem 2. Le signal est ainsi codé globalement en des mots comprenant deux octets de poids forts correspondant aux états des sorties $BS_i$ à $BS_o$ et deux octets de poids faible correspondant aux états des sorties $bs_i$ à $bs_o$. Chaque mot comprend au plus un bit à l'état "1" dans la paire d'octets de poids forts ou faibles. La vitesse d'émission du modem est déduite de la plus haute fréquence à transmettre et correspond à une cadence égale à la limite de fonctionnement du circuit de quantification réduite à celle du quantificateur QUA auquel s'ajoute des temps d'écriture $t_e$ et lecture $t_l$ de l'état d'une sortie $BS_o$ à $BS_l$.

Dans ce cas la limite $dt_{fL}$ de fonctionnement du circuit de quantification est :
$$dt_{fL} = t_{tr} + t_{in} + t_p + t_e + t_l$$
où $t_{tr}$, $t_{in}$ et $t_p$ désignent respectivement des temps de propagation des composants $tr_j$, $in_j$ et $p_j$ dans une cellule $c_j$. Numériquement, la relation précédente est en pratique :
$$dt_{fL} = 1\,ns + 15\,ns + 15\,ns + 20\,ns + 20\,ns \simeq 70\,ns$$

D'après les remarques et hypothèses faites plus haut, la relation qui lie la limite du temps de fonctionnement $dt_{fL}$ pour une opération de quantification et de codage et la fréquence F du signal appliqué est obtenue de la manière suivante. Pour un signal sinusoïdal $V = A.\sin(2\pi F/t)$, la variation de tension correspondant à $dt_{fL}$ est :
$$1/(4F) + (dt_{fL}/2)$$
$$\Delta V = A/8 = A.2\pi F. \cos (2\pi Ft).dt$$
$$1/(4F)-(dt_{fL}/2)$$
soit $1/8 = 1-\cos (\pi F\, dt_{FL})$
ou $\Pi F\, dt_{fL} = arc\, cos\, (0,875)$

La fréquence maximale admissible est ainsi :
$$F = 2. (0,65/\pi). (10^9/70)\, Hz = 4,85\, MHz$$
ce qui correspond en pratique à un groupe de $4850/4 = 1212$ voies téléphoniques.

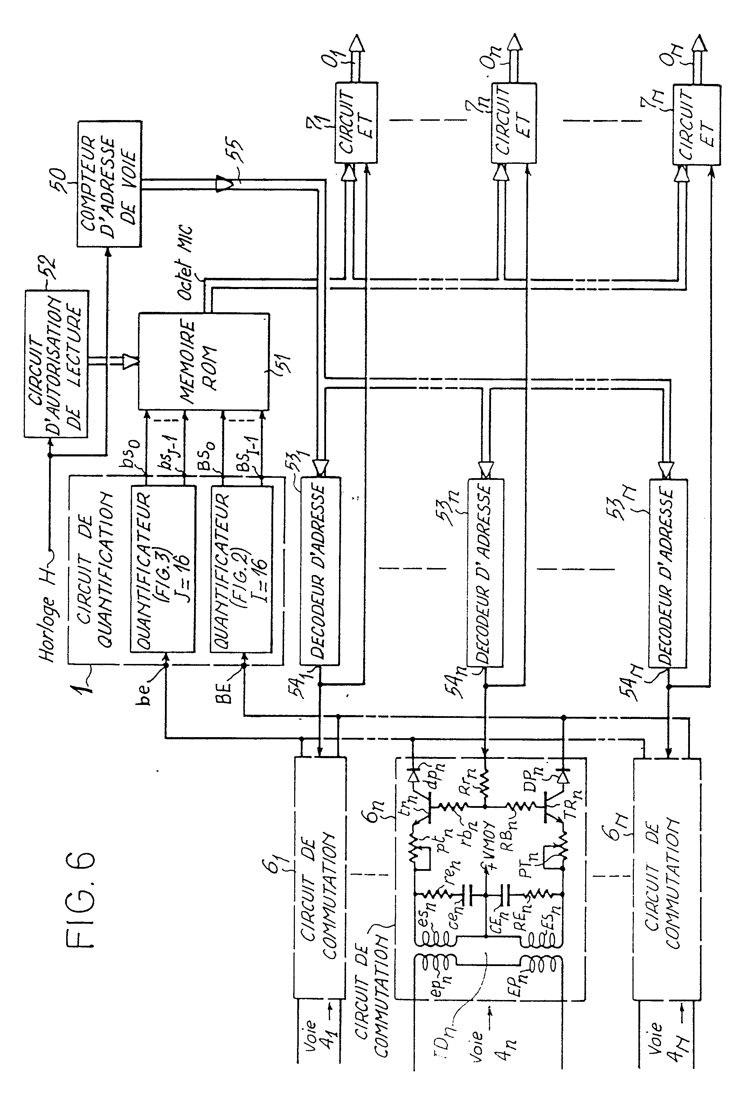

Selon une seconde application concernant un numériseur en mode conventionnel du genre MIC, le signal analogique entrant groupant des voies téléphoniques est numérisé en code MIC, ce qui se traduit par un codage des états des sorties du circuit de quantification 1 en un octet. Comme montré à la Fig.5, une mémoire morte ROM 30 est interconnectée entre les $I+J = 32$ sorties du circuit de quantification 1 et un modem MIC 31 afin de convertir périodiquement un mot à 32 bits sortant du circuit de quantification en un octet. En pratique, la mémoire contient 256 octets qui sont adressés respectivement par les couples ($BS_i =$ "1", $bs_j =$ "1").

Dans ce cas, aux opérations décrites pour la première application sont ajoutées des opérations d'adressage et lecture de la mémoire 30 et de transfert de celle-ci vers le modem 31, et une durée moyenne d'attente du signal numérisé due au fonctionnement synchrone du modem. Ces opérations supplémentaires peuvent être estimées à 70 ns.

Le total de l'opération de numérisation selon la seconde application conduit à une limite de fonctionnement $dt_{fL} = 140$ ns, soit le double de la précédente, et réduit dans le même rapport la fréquence maximale limite, soit ici égale à 2,425 MHz correspondant à un groupe de 606 voies téléphoniques.

Il est à noter que la vitesse de fonctionnement élevée du circuit de quantification permet de numériser un signal de télévision analogique entrant en un signal en code MIC ou plusieurs tels signaux, selon l'application décrite dans la suite en référence à la Fig.6. A la réception, chaque signal de télévision numérisé est converti en un signal analogique de télévision dans un décodeur comprenant un convertisseur numérique-analogique classique à réseau de résistances, diodes et/ou amplificateurs.

Selon une troisième application, le circuit de quantification 1 est destiné à quantifier cycliquement plusieurs signaux analogiques, tels que des signaux téléphoniques en bande de base transmis dans des lignes téléphoniques d'abonné $4_1$ à $4_N$, en vue de les convertir numériquement par exemple en code MIC.

Comme montré à la Fig.6, un dispositif de conversion analogique-numérique pour les N voies $4_1$ à $4_N$ comprend un compteur d'adresse 50, une mémoire ROM 51 à $I.J = 256$ octets, un circuit d'autorisation de lecture de mémoire 52, et le circuit de quantification 1 ayant $I+J = 32$ cellules, ainsi que des décodeurs d'adresse $53_1$ à $53_N$, des circuits de commutation $6_1$ à $6_N$ en entrée, et des circuits ET $7_1$ à $7_N$ en sortie associés respectivement aux voies $4_1$ à $4_N$.

Dans chaque circuit de commutation, tel que le circuit $6_n$ associé à la voie $4_n$ et montré en détail dans la Fig.6, on y retrouve un transformateur différentiel équilibré $TD_n$ à demi-enroulements primaires $EP_n$ et $ep_n$ et demi-enroulements secondaires $ES_n$ et $es_n$, deux potentiomètres $PT_n$ et $pt_n$ en série avec les demi-enroulements secondaires, et une borne de polarisation au point milieu entre les demi-enroulements secondaires $ES_n$ et $es_n$, portée à la tension moyenne VMOY. Le circuit de commutation $6_n$ comprend également deux inter-

rupteurs électroniques sous forme de deux transistors bipolaires NPN $TR_n$ et $tr_n$ ayant respectivement des émetteurs reliés aux potentiomètres $PT_n$ et $pt_n$, des collecteurs reliés à des anodes de diodes de protection $DP_n$ et $dp_n$ dont les cathodes sont respectivement reliées aux bornes d'entrée BE et be des quantificateurs QUA et qua, et des bases reliées à une borne de sortie $54_n$ du décodeur d'adresse $53_n$ à travers des résistances de bases $RB_n$ et $rb_n$ et une résistance commune $Rr_n$.

Des impulsions d'horloge H sont comptées par le compteur 50 qui délivrent pendant un cycle d'échantillonnage et de codage N adresses des voies $4_1$ à $4_N$ aux entrées des décodeurs $53_1$ à $53_N$, via un bus d'adresse 55. Lorsque le décodeur $53_n$ détecte l'adresse de la voie $4_n$ dans le bus 55, il marque sa sortie $54_n$ par une polarité positive, correspondant à l'état logique haut "1", pendant au plus une période d'horloge de rang n du cycle. Cet état "1" à la sortie $54_n$ débloque les transistors $TR_n$ et $tr_n$ sans les saturer et permet une quantification d'un échantillon du signal analogique dans la voie $4_n$ par les quantificateurs QUA et qua. Par contre, pendant les n-1 autres impulsions d'un cycle, le décodeur $53_n$ maintient à la masse ou état "0" la sortie $54_n$ ce qui bloque les transistors $TR_n$ et $tr_n$.

Les transistors $TR_n$ et $tr_n$ offrent une très grande impédance d'entrée de sorte que leur état débloqué ou bloqué ne modifie pas l'impédance de charge des enroulements secondaires du transformateur d'entrée $TD_n$. En outre, les transistors ont des impédances adaptées par des réseaux à capacité et résistance en série $RE_n$, $CE_n$ et $re_n$, $ce_n$ disposés respectivement en parallèle avec les demi-enroulements secondaires $ES_n$ et $es_n$. Ainsi une commutation à grande vitesse opérée par les transistors dans les circuits $6_1$ à $6_N$ ne perturbe pas, par des variations d'impédance et des réflexions parasites, le signal analysé. Les diodes $DP_1$ à $DP_N$ et $dp_1$ à $dp_N$ occultent des phénomènes transitoires apparaissant en début et en fin de commutation d'une voie.

Comme déjà dit en référence à la Fig.1, le point milieu du secondaire du transformateur d'entrée $TD_n$ dans le circuit $6_n$ est polarisé à +VMOY de manière à transposer dans une zone totalement positive l'analyse de la tension du signal entrant. Les résistances réglables $PT_n$ et $pt_n$ règlent la valeur moyenne du signal, en pratique égale à 0 Volt, aux niveaux de quantification correspondant aux cellules $C_{I/2-1} = C_7$ et $c_{J/2-1} = c_7$. Ces dispositions rendent le circuit de quantification 1 indifférent aux variations de la tension d'alimentation.

Du fait de la présence des diodes $DP_n$ et $dp_n$, lors de la sélection de la voie $4_n$, le signal dans cette voie est "placé" dans une plage de tensions quantifiables par une translation dans le sens croissant des tensions. Lors de la non sélection de cette même voie, le signal entrant est "descendu" par une translation inverse de la première. Ces "translations en tension" s'effectuent à la vitesse de commutation des transistors $TR_1$ à $TR_N$ et $tr_1$ à $tr_N$ qui, comme l'a vu, est inférieure à la nanoseconde, soit de l'ordre de quelques GHz. En raison de sa vitesse, ladite translation en tension n'est pas détectée par le dispositif de de quantification et codage dont la limite se situe à des vitesses plus faibles de l'ordre de quelques MHz.

Le décodeur d'adresse $53_n$ commande également par la sortie $54_n$ le circuit ET $7_n$ recevant un octet délivré par un bus de sortie 56 de la mémoire ROM 51, en réponse à une commande de lecture fournie par le circuit 52 à la cadence des impulsions d'horloge. La mémoire 51, comme la mémoire 30 montrée à la Fig.5, est adressée en lecture par les sorties $BS_0$ à $BS_{15}$ et $bs_0$ à $bs_{15}$ du circuit de quantification 1, et convertit ainsi chaque mot à 32 bits sortant du circuit 1 et résultant d'un échantillonnage de voie en un octet en code MIC. Les N octets $0_1$ à $0_N$ sortant successivement des circuits ET $7_1$ à $7_N$ peuvent être par exemple multiplexés temporellement en un signal numérique à débit élevé transmis par modem.

Pour cette troisième application, la durée de l'ensemble des opérations de quantification, d'adressage et de lecture et transmission de l'octet est estimé à 140 ns ce qui correspond à une fréquence maximale d'horloge de ≃ 7,1 MHz. Comme d'autre part, il s'agit de voies basse fréquence $4_1$ à $4_N$ ayant une bande passante limitée à 4000 Hz, ce qui correspond à une période de cycle d'échantillonnage maximum de 125 $\mu s$, c'est cette dernière qui impose sa contrainte et non plus les fréquences élevées du signal. Cela conduit à de meilleurs résultats.

On déduit dans ce cas, qu'un même dispositif de conversion analogique numérique quantifiant, codant et échantillonnant peut traiter à lui seul 125 000/140 = 892 voies téléphoniques.

Selon une autre variante, la mémoire 51 et les circuits ET $7_1$ à $7_N$ sont remplacés par N modems tels que le modem 2 de la Fig.4, adressés cycliquement par le circuit d'autorisation de lecture 52 faisant office de circuit de commande d'échantillonnage.

## Revendications

1 -Circuit de quantification d'un signal de tension entrant dans des premiers intervalles de tension consécutifs $((VT_0, VT_1)$ à $(VT_{l-1}, VT_l))$, comprenant des premières cellules $(C_0$ à $C_{l-1})$ pour respectivement détecter une tension instantanée du signal entrant dans les premiers intervalles, une détection par l'une $(C_i)$ des cellules étant signalée par un état logique prédéterminé ("1") à une borne de sortie $(BS_i)$ de ladite cellule et par l'autre état logique - ("0") à des bornes de sortie $(BS_0$ à $BS_{i-1}, BS_{i+1}$ à $BS_{l-1})$ des autres cellules $(C_0$ à $C_{i-1}, C_{i+1}$ à $C_{l-1})$ lorsque la tension instantanée est comprise dans le premier intervalle $(VT_i, VT_{i+1})$ associé à ladite cellule $(C_i)$, caractérisé en ce que chacune des premières cellules $(C_i)$ à l'exception de celle $(C_0)$ détectant une tension instantanée dans le premier intervalle $(VT_0, VT_1)$ ayant des plus petites limites, comprend des moyens de division de tension $(CD_i)$ pour détecter une tension limite inférieure $(VT_i)$ du premier intervalle respectif $(VT_i, VT_{i+1})$, lesdits moyens de division de tension comprenant une première diode $(D1_i)$, une seconde diode $(D2_i)$, un transistor $(TR_i)$, une première résistance $(R1_i)$ ayant une première borne reliée à la cathode de la première diode et à l'émetteur du transistor et une seconde borne reliée à la cathode de la seconde diode, à la base du transistor et à l'anode de la première diode $(D1_{i+1})$ dans la cellule suivante $(C_{i+1})$ associée au premier intervalle $(VT_{i+1}, VT_{i+2})$ immédiatement supérieur, et une seconde résistance $(R2_i)$ ayant une première borne reliée à l'anode de la seconde diode $(D2_i)$ et à une seconde borne de la seconde résistance $(R2_{i+1})$ dans ladite cellule suivante $(C_{i+1})$ et portée à une tension $(VT_i)$ sensiblement égale à une limite inférieure du premier intervalle respectif $(VT_i, VT_{i+1})$.

2 -Circuit conforme à la revendication 1, caractérisé en ce que les premières cellules $(C_1$ à $C_{l-1})$ à l'exception de celle $(C_0)$ associée au premier intervalle $(VT_0, VT_1)$ ayant des plus petites limites, comprennent des secondes résistances $(R2_1$ à $R2_{l-1})$ connectées en série entre des bornes $(0V, +V)$ d'une source d'alimentation déterminant des plus petite et grande limites de tension $(VT_0, VT_l)$ des premiers intervalles, de préférence à travers des résistances ajustables $(RA1, RA2)$.

3 -Circuit conforme à la revendication 1 ou 2, caractérisé en ce que chacune des premières cellules $(C_i)$ à l'exception de celle $(C_0)$ détectant une tension instantanée dans le premier intervalle $(VT_0, VT_1)$ ayant des plus petites limites, comprend des moyens de signalisation $(CS_i)$ activés par les moyens de division de tension $(CD_i)$ pour mettre la borne de sortie $(BS_i)$ de la cellule à l'état prédéterminé ("1") lorsque la tension instantanée est comprise dans le premier intervalle respectif - $(VT_i, VT_{i+1})$, et bloqués par au moins la cellule suivante $(C_{i+1})$ associée au premier intervalle $(VT_{i+1}, VT_{i+2})$ immédiatement supérieur pour mettre la borne de sortie $(BS_i)$ audit autre état logique ("0") lorsque la tension instantanée excède une tension limite supérieure $(VT_{i+1})$ du premier intervalle respectif.

4 -Circuit conforme à la revendication 3, caractérisé en ce que les moyens de signalisation - $(CS_i)$ dans chacune des premières cellules $(C_i)$ à l'exception des deux cellules $(C_0, C_l)$ détectant une tension instantanée dans des intervalles $((IT_0, IT_1), - (IT_{l-1}, IT_l))$ ayant des plus petites et grandes limites, comprennent une porte ET à deux entrées $(P_i)$ ayant une première entrée reliée à une sortie de commande $(R3_i)$ des moyens de division de tension $(CD_i)$ de la cellule $(C_i)$ et une sortie constituée par ladite borne de sortie $(BS_i)$ de la cellule $(C_i)$, une première diode $(D3_i)$ ayant une anode reliée à une seconde entrée de la porte ET $(P_i)$ à travers un inverseur $(IN_i)$ et à une cathode de la première diode $(D3_{i+1})$ dans les moyens de signalisation - $(CS_{i+1})$ de la cellule suivante $(C_{i+1})$ associée au premier intervalle $(VT_{i+1}, VT_{i+2})$ immédiatement supérieur, et une seconde anode $(D4_i)$ ayant une diode reliée à la borne de sortie $(BS_i)$ de la cellule et une cathode reliée à la cathode de la première diode $(D3_i)$, en ce que la première cellule $(C_0)$ associée à l'intervalle ayant les plus petites limites ne comprend qu'un inverseur $(IN_0)$ interconnecté entre la borne de sortie $(BS_0)$ de la cellule $(C_0)$ et les cathodes des première et seconde diodes $(D3_1, D4_1)$ dans les moyens de signalisation $(CS_1)$ de la cellule suivante $(C_1)$, et en ce que les moyens de signalisation $(CS_{l-1})$ dans la première cellule $(C_{l-1})$ associée à l'intervalle ayant les plus grandes limites ne comprend qu'une première diode $(D3_{l-1})$ interconnectée entre la sortie de commande $(R3_{l-1})$ des moyens de division de tension respectif $(CD_{l-1})$ et la borne de sortie $(BS_{l-1})$ de la cellule d'une part, et l'anode de la première diode $(D3_{l-2})$ dans les moyens de signalisation $(CS_{l-2})$ de la cellule précédente $(C_{l-2})$ d'autre part.

5 -Circuit conforme à l'une quelconque des revendications 1 à 4, caractérisé en ce qu'il comprend des moyens d'entrée $(TD)$ ayant une sortie reliée à une borne d'entrée $(BE)$ de la première cellule $(C_1)$ associée à l'intervalle immédiatement supérieur à celui ayant les plus petites limites pour polariser positivement l'amplitude crête-à-crête du signal entrant.

6 -Circuit conforme à la revendication 5, caractérisé en ce que les moyens d'entrée $(TD)$ polarisent le signal entrant à une tension de polarisation positive sensiblement égale à une tension moyenne $(VMOY)$ des plus petite et grande limites $(VT_0, VT_l)$ des premiers intervalles.

7 -Circuit conforme à la revendication 5 ou 6, caractérisé en ce que les moyens d'entrée (TD) comprennent un transformateur différentiel ayant un enroulement primaire (EP, ep) recevant le signal entrant, et un premier demi-enroulement secondaire (ES) interconnecté entre une borne de tension de polarisation positive (VMOY) et une entrée (BE) de ladite première cellule ($C_i$) associée à l'intervalle immédiatement supérieur, de préférence à travers une résistance ajustable (PT).

8 -Circuit conforme à l'une quelconque des revendications 1 à 7, caractérisé en ce qu'il comprend des premiers moyens (QUA) incluant lesdites premières cellules ($C_o$ à $C_{l-1}$) pour quantifier le signal entrant dans les premiers intervalles (($VT_o$, $VT_1$) à ($VT_{l-1}$, $VT_l$)), et des seconds moyens (qua) incluant des secondes cellules ($c_o$ à $c_{J-1}$) analogues aux premières cellules et des moyens de sélection de tension (RDR1, RDR2) pour appliquer auxdites secondes cellules des tensions limites du premier intervalle ($VT_i$, $VT_{i+1}$) associé à une première cellule détectant ($C_i$) ayant une borne de sortie ($BS_i$) audit état logique prédéterminé ("1") afin que lesdites secondes cellules ($c_o$ à $c_{J-1}$) détectent respectivement une tension instantanée du signal entrant dans des seconds intervalles de tension consécutifs (($vt_o$, $vt_1$), ($vt_{J-1}$, $vt_J$)) partageant le premier intervalle ($VT_i$, $VT_{i+1}$) associé à la première cellule détectant ($C_i$).

9 -Circuit conforme à la revendication 8, caractérisé en ce que les secondes cellules ($c_1$ à $c_{J-1}$) à l'exception de celle ($c_o$) associée au second intervalle ($vt_o$, $vt_1$) ayant des plus petites limites, comprennent des secondes résistances ($r2_1$ à $r2_{J-1}$) connectées en série entre deux bornes de sortie des moyens de sélection de tension (RDR1, RDR2) sensiblement portées aux tensions limites du premier intervalle ($VT_i$, $VT_{i+1}$) de la cellule détectant ($C_l$).

10 -Circuit conforme à la revendication 8 ou 9, caractérisé en ce que les moyens de sélection de tension comprennent plusieurs résistances ($R4_{l-1}$ à $R4_o$) reliées en série à une borne de la série de résistances ($r2_1$ à $r2_{J-1}$) dans les secondes cellules, de préférence à travers une résistance ajustable (ra1), et reliées respectivement aux bornes de sortie ($BS_{l-1}$ à $BS_o$) des premières cellules ($C_{l-1}$ à $C_o$) à travers des diodes ($D5_{l-1}$ à $D5_o$) et des inverseurs (IN1$_{l-1}$ à IN1$_o$), et plusieurs résistances ($R5_o$ à $R5_{l-1}$) reliées en série à une autre borne de ladite série de résistances ($r2_1$ à $r2_{J-1}$) dans les secondes cellules, de préférence à travers une résistance ajustable (ra2), et reliées respectivement aux bornes de sortie ($BS_o$ à $BS_{l-1}$) des premières cellules ($C_o$ à $C_{J-1}$) à travers des diodes ($D6_o$ à $D6_{l-1}$).

11 -Circuit conforme à la revendication 7 et à l'une quelconque des revendications 8 à 10, caractérisé en ce que ledit transformateur différentiel (TD)) a un second demi-enroulement secondaire (es) interconnecté entre la borne de tension de polarisation positive (VMOY) et une entrée (be) de la seconde cellule ($c_i$) des seconds moyens pour quantifier (qua) associée au second intervalle ($vt_1$, $vt_2$) immédiatement supérieur au second intervalle ($vt_o$, $vt_1$) ayant les plus petites limites, de préférence à travers une résistance ajustable (pt).

12 -Dispositif pour convertir un signal analogique en un signal numérique (FIG.4), caractérisé en ce qu'il comprend un circuit de quantification (1) conforme à l'une quelconque des revendications 1 à 11, recevant le signal analogique, et un modem (2) pour échantillonner et moduler des signaux logiques délivrés par les sorties ($BS_o$ à $BS_{l-1}$, $bs_o$ à $bs_{J-1}$) du circuit de quantification.

13 -Dispositif pour convertir un signal analogique en un signal numérique (FIG.5), caractérisé en ce qu'il comprend un circuit de quantification (1) conforme à l'une quelconque des revendications 1 à 11, recevant le signal analogique et offrant I + J sorties de cellule ($BS_o$ à $BS_{l-1}$, $bs_o$ à $bs_{J-1}$), et des moyens (30) pour convertir périodiquement un mot constitué par I + J bits ayant les états logiques des bornes de sortie ($BS_o$ à $BS_l$, $bs_o$ à $bs_j$) du circuit de quantification (1) en un mot codé ayant $Log_2 IJ$ bits, et de préférence un modem (2) pour moduler les mots codés.

14 -Dispositif pour convertir des signaux analogiques ($4_1$ à $4_N$) en des signaux numériques ($D_1$ à $D_N$), caractérisé en ce qu'il comprend un circuit de quantification (QUA, qua) du genre de celui défini dans l'une quelconque des revendications 1 à 11, plusieurs moyens de commutation ($6_1$ à $6_N$) recevant respectivement les signaux analogiques pour appliquer sélectivement et périodiquement des échantillons des signaux analogiques ($4_1$ à $4_N$) au circuit de quantification, et plusieurs moyens de sortie ($5_1$, $7_1$, à $7_N$) associés respectivement aux signaux analogiques pour convertir des mots prélevés périodiquement aux sorties ($BS_o$ à $BS_{l-1}$, $bs_o$ à $bs_{J-1}$) du circuit de quantification en des mots de codage (octets) d'échantillons des signaux analogiques.

15 -Dispositif conforme à la revendication 14, caractérisé en ce que le circuit de quantification comprend des premiers et seconds moyens de quantification (QUA, qua) conformes à la revendication 8, et en ce que chacun des moyens de commutation ($6_n$) comprend un transformateur différentiel ($TD_n$) ayant un enroulement primaire ($EP_n$, $ep_n$) recevant le signal analogique associé ($4_n$) et deux demi-enroulements secondaire ($ES_n$, $es_n$) ayant une borne commune portée à une tension positive, de préférence égale à une tension moyenne (VMOY) dudit signal analogique associé, et d'autres bornes reliées respectivement à des bornes d'entrée (BE, be) des premier et second

11

moyens de quantification (QUA, qua) à travers des interrupteurs électroniques ($TR_n$, $tr_n$), tels que transistors, et de préférence à travers des résistances ajustables ($PT_n$, $pt_n$) et des diodes ($DP_n$, $dp_n$), les interrupteurs électroniques ($TR_n$, $tr_n$) étant fermés périodiquement sous la commande de moyens d'adressage (50, $53_n$).

FIG.1

CIRCUIT DE QUANTIFICATION 1

QUANTIFICATEUR (FIG.3)

qua

CODAGE (FIGs. 4,5,6)

RESEAU DE DIODES ET RESISTANCES RDR1

RDR2 RESEAU DE DIODES ET RESISTANCES

Signal entrant

+VMOY

QUANTIFICATEUR (FIG.2)

CIRCUITS DE SIGNALISATION

CIRCUITS DE DETECTION

QUA

0 235 483

FIG.2

Vers CODAGE (FIGS. 4,5,6)

Vers RDR1, RDR2 (FIG.3)

QUANTIFICATEUR QUA

Signal analogique entrant

QUANTIFICATEUR *qua* — *VERS CODAGE (FIGS.4,5,6)* — FIG.3

de $BS_0$ à $BS_{I-1}$ (FIG.2)

## FIG. 4

CIRCUIT DE QUANTIFICATION

$bs_0$

$bs_{J-1}$

$BS_0'$

$BS_{I-1}'$

$J = 16$
2 octets de poids faible

$I = 16$
2 octets de poids fort

MODEM ASYNCHRONE

Signal analogique entrant

## FIG. 5

Signal analogique entrant

CIRCUIT DE QUANTIFICATION

$bs_0$

$bs_{J-1} = bs_{15}$

$BS_0'$

$BS_{I-1}' = BS_{15}$

MEMOIRE ROM

Octet MIC

MODEM

0 235 483

FIG. 6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-3 585 631 (WESTINGHOUSE ELECTRIC CORP.) * Colonne 1, lignes 22-58; figure * | 1-3,8, 12,14 | H 03 M 1/34 H 03 M 1/14 |
| | --- | | |
| A | US-A-3 735 390 (IBM) * Colonne 2, lignes 14-30; figures 1-3 * | 1-4 | |
| | --- | | |
| A | DE-A-2 737 024 (N.V. PHILIPS' GLOEILAMPENFABRIEKEN) * Page 22, ligne 5 - page 27, ligne 23; figure 6 * | 1-4,8, 12 | |
| | ----- | | |

**DOMAINES TECHNIQUES RECHERCHES (Int. Cl.4)**

H 03 M 1/00

Le présent rapport de recherche a été établi pour toutes les revendications

| Lieu de la recherche | Date d'achèvement de la recherche | Examinateur |
|---|---|---|
| LA HAYE | 18-02-1987 | NUSSBAUMER C.P. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publie a la date de dépôt ou après cette date
D : cité dans la demande
L : cité pour d'autres raisons

& : membre de la même famille, document correspondant

OEB Form 1503 03 82